# EUROPÄISCHE PATENTANMELDUNG

(11) **EP 3 608 936 A1**
(43) Veröffentlichungstag der Anmeldung: **12.02.2020**
(21) Anmeldenummer: 18187560.0
(22) Anmeldetag: 06.08.2018
(51) Int. Cl.: H01H 9/16, H03K 17/94

(54) **VORRICHTUNG ZUM ERKENNEN EINES SCHALTVORGANGS ÜBER EINEN SPALT HINWEG**

(71) Anmelder: EAO Holding AG, 4600 Olten (CH)
(72) Erfinder: Fritschi, Markus, 5745 Safenwil (CH)
(74) Vertreter: Liebetanz, Michael

(57) **Zusammenfassung**

Eine Vorrichtung zum Erkennen eines Schaltvorgangs über einen Spalt hinweg umfasst einen RF-Sensor mit einem Oszillator und einem LC-Glied und einen RF gekoppelten Schalter (100), umfassend ein Schaltglied (55), wobei der Schalter (100) im Abstand des Spaltes gegenüber dem LC-Glied des RF-Sensors angeordnet ist. Dabei verfügt der RF gekoppelte Schalter (100) über eine aus mindestens einer Windung bestehenden Antennenspule (51), einen Kondensator (54) und ein Schaltorgan (55) in einem geschlossenen Kreis (53). Dabei weist das aus Antennenspule (51) und Kondensator (54) gebildete LC-Glied im Wesentlichen die gleiche Frequenz wie das LC-Glied des RF-Sensors auf, so dass bei einer Änderung des Schaltorgans (55) ein entstehender Unterschied in der Last des LC-Gliedes des RF-Sensors durch eine Auswerteschaltung erfassbar ist.

## Beschreibung

### TECHNISCHES GEBIET

Die vorliegende Erfindung betrifft eine Vorrichtung zum Erkennen eines Schaltvorgangs über einen Spalt hinweg, mit einem RF-Sensor, umfassend einen Oszillator und ein LC-Glied, mit einem RF gekoppelten Schalter, umfassend ein Schaltglied, wobei der Schalter im Abstand des Spaltes gegenüber dem LC-Glied des RF-Sensors angeordnet ist.

### STAND DER TECHNIK

Aus der EP 2 552 031 A1 ist ein Türöffnerschalter mit einem Taster bekannt, mit dem über eine kapazitive Kopplung durch eine Wand aus nicht magnetisierbarem Material hindurch vom Taster erzeugte Signale über eine kapazitive Signalübertragungseinrichtung ableitbar sind.

Aus der US 6,274,829 ist ein drahtloser induktiv gekoppelter Schalter mit den Merkmalen des Oberbegriffs des Anspruchs 1 bekannt. Ein handelsüblicher induktiver Näherungssensor wird gegenüber dem induktiv gekoppelten Schalter angeordnet, der einen Bimetallkern und eine um die beiden Abschnitte des Kerns angeordnete Spule aufweist.

Aus der EP 1 286 478 ist es bekannt, bei einer Bustüre die Information der taktilen Sensorelemente eines Klemmschutzsystems der Tür mit Hilfe von Transpondern an den Türrahmen selber zu übertragen. Dies ermöglicht es, die auf der Tür des Fahrzeugs selber angebrachten Sensorelemente in drahtloser Weise mit der Auswerteelektronik, die am Türrahmen oder sonst fest im Bus installiert ist, zu verbinden. Diese Transponder für die Sensorelemente eines Klemmschutzsystems sind im Kantenbereich der Tür gegenüber dem Chassis angeordnet.

### DARSTELLUNG DER ERFINDUNG

Ausgehend von dem Stand der Technik ist es eine Aufgabe der vorliegenden Erfindung einen einfacheren drahtlosen RF gekoppelten Schalter anzugeben, der nicht die Nachteile des Standes der Technik hat, wie beispielsweise, dass ein Bimetallkern notwendig ist.

Dieser steht zudem im Wesentlichen senkrecht auf der die Lücke bildende Ebene, so dass die Einheit von zylindrischem Bimetallkern und komplementären induktivem Näherungssensor eine grosse Bauhöhe ergeben.

Diese Aufgabe wird erfindungsgemäss mit den Merkmalen des Anspruchs 1 gelöst. Dabei ist von Vorteil, dass bei der Antenne eine einzelne Schlaufe mit einem Durchmesser von 2 bis 6 Zentimeter ausreichend ist, um ein ausreichendes Signal zu erzeugen. Der Leistungsbedarf auf RF-Sensorseite liegt im Milliwattbereich. Bei einem Schalter ist die statische Schaltfunktion klar. Bei Einsatz eines Tasters kann dieser langsam ausgelöst werden, also beispielsweise eine federnde Tastscheibe langsam durchgedrückt werden; dies führt in gleicher Weise zu einer Funktionsauslösung wie ein schnelles Drücken eines Tasters. Da die Schaltereinheit nur wenige kapselbare Elemente umfasst, ist ein Einsatz in verschiedenen auch harten Umgebungen möglich.

Bei einer Vorrichtung zum Erkennen eines Schaltvorgangs über einen Spalt hinweg ist ein RF-Sensor vorgesehen, der einen Oszillator und ein LC-Glied umfasst. Ferner ist ein RF gekoppelter Schalter vorgesehen, der ein Schaltglied umfasst, wobei der Schalter im Abstand des Spaltes gegenüber dem LC-Glied des RF-Sensors angeordnet ist. Dabei verfügt der RF gekoppelte Schalter über eine aus mindestens einer Windung bestehenden Antennenspule, über einen Kondensator und über ein Schaltorgan in einem geschlossenen Kreis, wobei das aus Antennenspule und Kondensator gebildete LC-Glied im Wesentlichen bei einer vorbestimmten Synchronisationsstellung des Schaltorgans die gleiche Frequenz wie das LC-Glied des RF-Sensors aufweist, so dass bei einer Änderung der Stellung des Schaltorgan ein entstehender Unterschied in der Last des LC-Glied des RF-Sensors durch eine Auswerteschaltung erfassbar ist.

Vorteilhafterweise ist das Schaltorgan ein Schalter, ein Taster oder ein Element zum Verstimmen des Schwingkreises.

Die Änderung des Schaltorgans kann eine Aktion aus der Gruppe des Schliessens eines Schalters oder Tasters, Öffnen eines Schalters oder Tasters oder Verstimmen des Schwingkreises umfassen.

Die Antennenspule ist vorteilhafterweise parallel zur Ebene des Spaltes in einer Antennenebene angeordnet ist. Es kann aber auch abgesetzt und in einer anderen Ebene angeordnet sein und das Schaltorgan ist ein Taster, der beliebig angeordnet sein kann, vorteilhafterweise im Bereich der Antennenspule, insbesondere mittig zur Antennenspule, und von der vom Spalt abgewandten Seite des RF gekoppelten Schalters nahe der Antennenebene betätigbar ist. Die Antenne kann beispielsweise auch in einem 45 bis 80 Grad Winkel schräg vorgesehen sein; insbesondere 60 Grad sind ebenfalls möglich.

Das Schaltorgan und der Kondensator können parallel zueinander geschaltet sind. Dann wird der bei einem geöffneten Schalter bestehende LC-Schaltkreis bei einem Schliessen des Schalters kurzgeschlossen.

Das Schaltorgan kann auch in Serie mit einem Kondensator geschaltet ist, wobei diese Serienverbindung parallel zu einem Basiskondensator geschaltet ist. Dann ist bei einem geöffneten Schalter nur der Basiskondensator für die Übereinstimmung mit dem LC-Schaltkreis des Oszillators relevant, während bei geschlossenem Schalter dies beide Kondensatoren sind.

Das Schaltorgan kann auch parallel zu einem weiteren Kondensator geschaltet sein, wobei diese parallel geschalteten Elemente Schaltorgan und weiterer Kondensator in Serie mit einem Basiskondensator an den Eingang der Antennenschaltung geschaltet sind.

Schliesslich können auch zwei Schaltorgane in Serie mit jeweils einem Kondensator geschaltet sein, wobei diese zwei Serienverbindungen parallel zu dem Eingang der Antennenschaltung geschaltet sind. Dabei ist bei unterschiedlichen Kondensatoren auch feststellbar, welcher der beiden Schalter oder Taster betätigt worden sind.

Gemäss einer anderen Ausführungsform kann die Vorrichtung parallel zu einer Serienschaltung des Kondensators mit einer ersten Teilinduktivität der Antennenschaltung dann das besagte Schaltorgan parallel zu einer zweiten Teilinduktivität der Antennenschaltung geschaltet werden. Dann wird der LC-Schaltkreis auf Antennenseite durch Änderung der Induktivität beim Schalten verstimmt.

Dabei können die beiden ersten und zweiten Teilinduktivitäten der Antennenschaltung durch einen zwischen diesen vorgesehenen Zwischenabgriff durch die Verbindung zum Schaltorgan realisiert sein. Das kann insbesondere einfach durch Realisierung jeder der ersten und zweiten Teilinduktivitäten durch eine vorbestimmte Anzahl von Windungen der Antennenschaltung geschehen.

Wenn für 2 Kanäle zwei Schaltorgane vorgesehen sind, die jeweils parallel zu einer zugeordneten Teilinduktivität der Antennenschaltung und parallel zu einer Serienschaltung des Kondensators mit der ersten Teilinduktivität der Antennenschaltung geschaltet sind, ist ein einfaches Beispiel einer Mehrkanalschaltung angegeben.

Weitere Ausführungsformen sind in den abhängigen Ansprüchen angegeben.

### KURZE BESCHREIBUNG DER ZEICHNUNGEN

Bevorzugte Ausführungsformen der Erfindung werden im Folgenden anhand der Zeichnungen beschrieben, die lediglich zur Erläuterung dienen und nicht einschränkend auszulegen sind. In den Zeichnungen zeigen:
- Fig. 1: zeigt eine schematische Skizze eines RF gekoppelten Schalters mit Näherungssensor und Auswerteschaltung;
- Fig. 2: zeigt eine schematische Schaltungsskizze eines ersten Ausführungsbeispiels eines RF gekoppelten Schalters gemäss der Erfindung;
- Fig. 3: zeigt eine schematische Schaltungsskizze eines zweiten Ausführungsbeispiels eines RF gekoppelten Schalters gemäss der Erfindung;
- Fig. 4: zeigt eine schematische Schaltungsskizze eines dritten Ausführungsbeispiels eines RF gekoppelten 2-Kanal Schalters gemäss der Erfindung, wobei immer ein Schwingkreis aktiv ist;
- Fig. 5: zeigt eine schematische Schaltungsskizze eines vierten Ausführungsbeispiels eines RF gekoppelten 2-Kanal Schalters gemäss der Erfindung, wobei immer ein Schwingkreis aktiv ist;
- Fig. 6: zeigt eine schematische Schaltungsskizze eines fünften Ausführungsbeispiels eines RF gekoppelten 2- oder mehr-Kanal Schalters gemäss der Erfindung;
- Fig. 7: zeigt eine schematische Schaltungsskizze eines sechsten Ausführungsbeispiels eines RF gekoppelten 2- oder mehr-Kanal Schalters gemäss der Erfindung in einer Sicherheitsschaltung;
- Fig. 8: zeigt eine schematische Schaltungsskizze eines siebten Ausführungsbeispiels eines RF gekoppelten Schalters gemäss der Erfindung;
- Fig. 9: zeigt eine schematische Schaltungsskizze eines achten Ausführungsbeispiels eines RF gekoppelten 2-Kanal Schalters gemäss der Erfindung, wobei immer ein Schwingkreis aktiv ist; und
- Fig. 10: zeigt eine schematische Schaltungsskizze eines neunten Ausführungsbeispiels eines RF gekoppelten 2-Kanal Schalters gemäss der Erfindung.

### BESCHREIBUNG BEVORZUGTER AUSFÜHRUNGSFORMEN

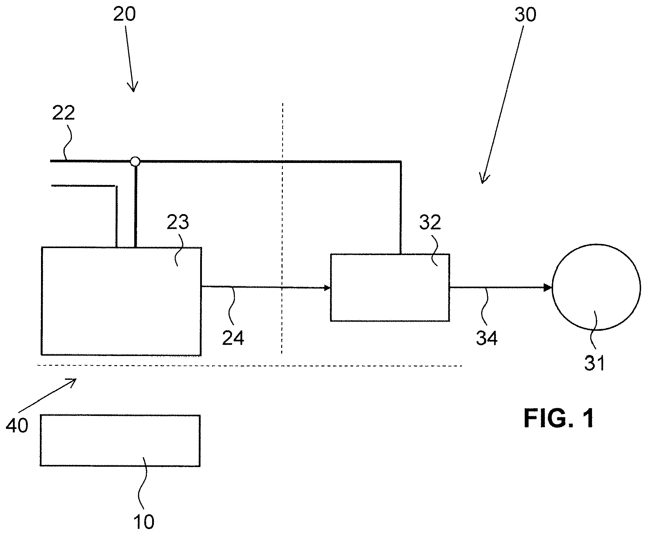

Die Fig. 1 zeigt eine schematische Skizze eines RF gekoppelten Schalters 10 mit Näherungssensor 20 und Auswerteschaltung 30, die hier mit einer Anzeige 31 versehen ist. Dies kann statt der Anzeige auch ein Aktuator sein. Auf der Senderseite besteht eine Speisespannung 22, mit der die eigentliche Auswerteelektronik 32 und ein Oszillator mit LC-Schwingkreis 23 gespeist werden. Das Ausgangssignal 24 des Oszillator und LC-Schwingkreises 23 wird der Auswerteelektronik 32 zugeführt, die bei Auslösen des gekoppelten Tasters oder Schalters 10 dieses erkennt und ein Schaltsignal 34 ausgibt, welches beispielsweise eine LED-Anzeige 31 oder einen Türöffnungsmechanismus ansteuern kann.

Der RF gekoppelte Schalter 10 ist gegenüber dem Oszillator mit LC-Schwingkreis 23 in einem eine Lücke 40 definierenden Abstand angeordnet. Der Abstand kann dabei von Null bis zu einem von der Anwendung abgängigen und vorgegebenen Abstand variieren. Diese Lücke oder dieser Spalt kann beispielsweise von einer Glasscheibe, einer Doppelglasscheibe mit Luftspalt, einer Holzplatte oder Kunststoff gefüllt sein, wobei dann zum Beispiel die Doppelglasscheibe diesen Abstand vorgibt. Es ist für den Zwischenraum jeweils ein nicht leitendes Material vorzusehen. Der Abstand kann im Zentimeterbereich, im Dezimeterbereich bis hin zu Metern liegen.

Der Oszillator mit LC-Schwingkreis 23 kann eine Frequenz von beispielsweise 16 Megahertz haben. Übliche Frequenzen liegen zwischen 0,1 bis 500 Megahertz, insbesondere 10 und 50 Megahertz, wobei höherer Frequenzen kleinere Durchmesser der Antennen und damit der Schalteranlagen ermöglichen. Die Frequenz kann in Abhängigkeit von den Rahmenbedingungen frei angepasst werden. Hier kann auf der Oszillatorseite eine Antenne mit vier Windungen in einem Kreis von ca. 25 Millimeter vorgesehen sein.

Auf Tasterseite kann beispielsweise eine Antenne mit zwei Windungen und einem Durchmesser von 70 Millimetern mit einem Draht von 0,25 Millimeter genommen werden.

Für die Auswertung sind verschiedene Ansätze möglich. So kann die Amplitude des Schwingkreises auf der Oszillatorseite gemessen werden .Wird der Schwingkreis durch Schliessen des Tasters 55 belastet, so sinkt die Amplitude. Es ist auch möglich, den Leistungsverbrauch vom Oszillator auszuwerten. Die Leistung steigt, wenn der Schwingkreis belastet wird. Die Resonanzfrequenz kann auch direkt ermittelt werden. Dies ist der bevorzugte Weg, wenn mit der Schaltung mehrere Schaltkanäle ausgewertet werden sollen.

Die Abstimmung des LC-Schwingkreises auf der Tasterseite hat auf die gleiche Frequenz wie die vom Sender zu geschehen. Wenn der LC-Schwingkreis auf Tasterseite aktiv ist, dann wird der Oszillator mehr belastet. Dabei kann zum Schalten der Schwingkreis verstimmt, kurzgeschlossen oder geöffnet werden. In den vorliegenden Figuren wird der Taster 55 immer in der geschlossenen Funktion als auslösendes Moment gezeigt. Bei Sicherheitsanwendungen kann er im Regelfall aber geschlossen sein und zum Auslösen geöffnet werden. Bei Ausführungen mit einer 2-Kanal Vorrichtung ist immer ein LC-Schwingkreis aktiv. Es ist dann nicht relevant, ob der Schalter im Regelfall geschlossen oder offen ist.

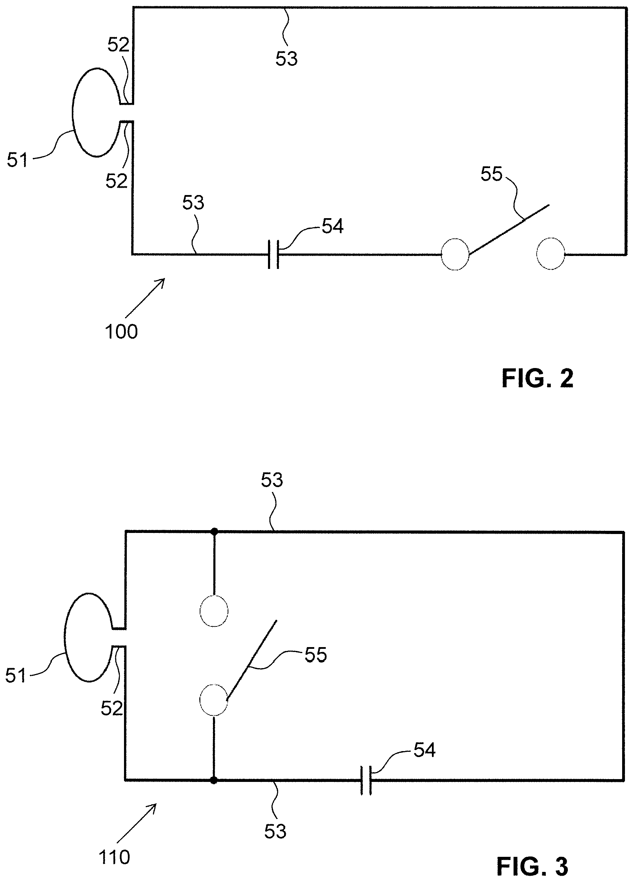

Die Fig. 2 zeigt eine schematische Schaltungsskizze eines ersten Ausführungsbeispiels eines RF gekoppelten Schalters 100 gemäss der Erfindung. Dabei ist in einer Ebene parallel zum Spalt 40 eine Antenne 51 angeordnet. Diese besteht im einfachsten Fall aus einem isolierten Draht der zu einem geschlossenen Gebilde, insbesondere einem Kreis, einem Polygonzug, wie einem Rechteck oder Quadrat, etc. in der besagten Ebene gebogen ist. Von einer Isolierung des Drahtes kann abgesehen werden, wenn in der Umgebung des Drahtes keine leitenden Materialien vorgesehen sind. Der Draht kann auch als PCB-Leiterplattenelement vorliegen. Wesentlich ist nur das Bestehen einer zumindest kleinen Fläche im Innern der Drahtschlaufe(n).

Es können auch mehrere Schlaufen und Windungen bestehen. Die beiden freien Enden 52 der Leitungen der Antenne 51 sind mit einem der Kontakte eines Tasters oder Schalters 55 verbunden. Dabei führt eine der Drahtverbindungen 53 über einen Kondensator 54, so dass sich auf der Schalterseite ein einfaches LC-Glied ergibt, bei dem Kondensator 54 und Schalter 55 in Reihenschaltung zu den freien Enden 52 des induktiven Glieds 51 angeordnet sind.

Die Fig. 3 zeigt eine schematische Schaltungsskizze eines zweiten Ausführungsbeispiels eines gekoppelten Schalters 110 gemäss der Erfindung. Gleiche Merkmale sind in allen Zeichnungen mit gleichen Bezugszeichen versehen worden. Hier ist der Schalter oder Taster 55 in parallel zum Kondensator 54 an den freien Enden 52 der aus einem Kreisförmig angeordneten Draht bestehenden Antenne geschaltet.

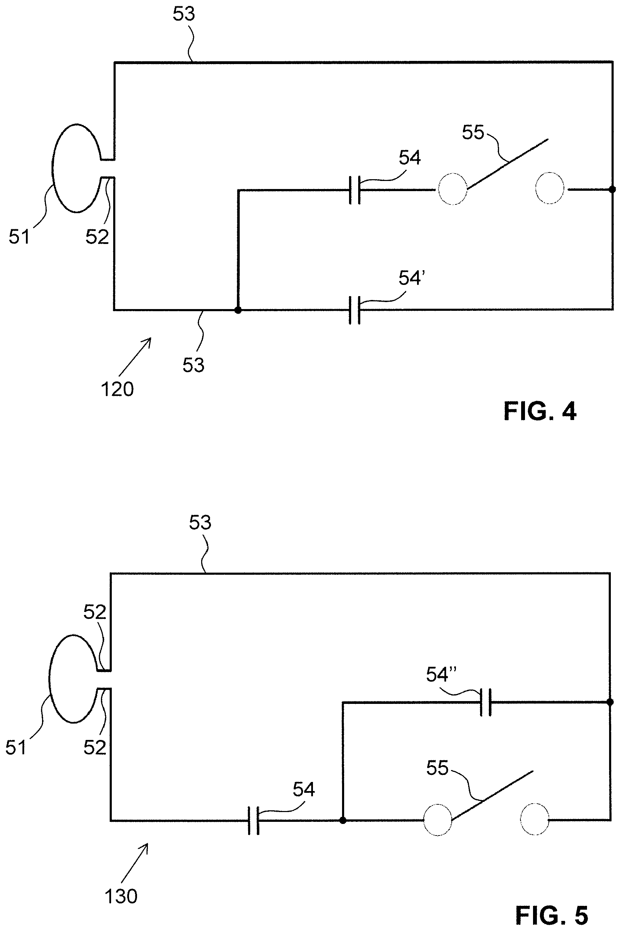

Die Fig. 4 zeigt eine schematische Schaltungsskizze eines dritten Ausführungsbeispiels eines RF gekoppelten Schalters 120 gemäss der Erfindung. Hier ist zusätzlich zu der Ausgestaltung des Schalters 100 nach Fig. 2 zusätzlich ein weiterer Kondensator 54' parallel zum ersten Kondensator 54 und Taster 55 vorgesehen, also ebenfalls mit den freien Enden der Antenne verbunden. So ist immer ein Schwingkreis aktiv.

Die Fig. 5 zeigt eine schematische Schaltungsskizze eines vierten Ausführungsbeispiels eines RF gekoppelten Schalters 130 gemäss der Erfindung. Hier ist zusätzlich zu der Ausgestaltung des Schalters 100 nach Fig. 2 zusätzlich ein weiterer Kondensator 54" parallel zum Taster 55 vorgesehen. Im Gegensatz zum Ausführungsbeispiel nach Fig. 3 überbrückt der weitere Kondensator 54" nur den Taster 55 und ist in Reihe mit dem ersten Kondensator 54 geschaltet.

Bei den beiden Ausführungsbeispielen nach Fig. 4 und Fig. 5 besteht bei geöffnetem (und auch bei geschlossenem) Taster 55 ein geschlossener LC-Kreis, bei dem Ausführungsbeispiel nach Fig. 4 bestehend aus dem Kondensator 54', bei dem Ausführungsbeispiel nach Fig. 5 bestehend aus den in Serie geschalteten Kondensatoren 54 und 54", was eine erste Frequenz festlegt. Bei Schliessen des Tasters 55 verändert sich die Kapazität beim Ausführungsbeispiel nach Fig. 4 zur Summe der beiden Kondensatoren 54 und 54' während sie sich beim Ausführungsbeispiel nach Fig. 5 auf die Kapazität des Kondensators 54 verändert. Somit besteht auf Tasterseite eine zweite Frequenz. Der Unterschied zwischen den beiden Frequenzen ergibt sich je nachdem, ob der Taster 55 betätigt ist oder nicht. Wenn aus einem Grund die Tasterseite fehlt, wie Vandalismus durch Entfernen eines auf einer Scheibe aufgeklebten Tastereinheit gegenüber der inneren Auswerteeinheit, ist weder die erste noch die zweite Frequenz nachweisbar und somit eine Störung als dritte Information ermittelbar. Wenn gegenüber der inneren Auswerteeinheit / Näherungsschalter einfach ein Metallstück hingehalten werden würde, so würden beide Frequenzen aktiviert und es kann ebenfalls ein Störungssignal abgeleitet werden.

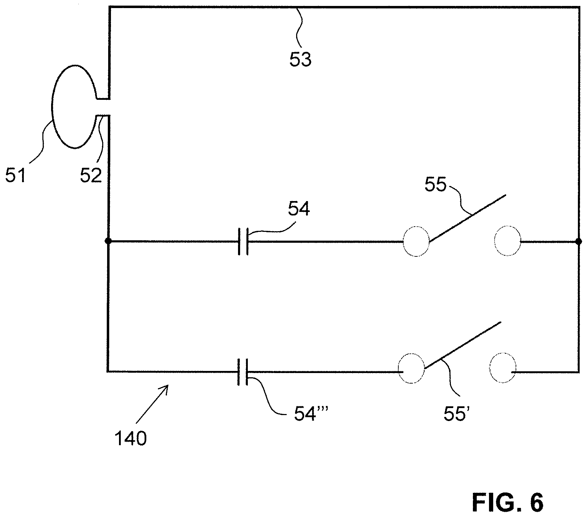

Die Fig. 6 zeigt eine schematische Schaltungsskizze eines fünften Ausführungsbeispiels eines RF gekoppelten Schalters 140 gemäss der Erfindung. Hier ist zusätzlich zu der Ausgestaltung des Schalters 100 nach Fig. 2 zusätzlich ein weiteres Kondensator 54'" und Taster 55' Paar vorgesehen, die parallel zum ersten Kondensator 54 und ersten Taster 55 geschaltet sind. Somit können auch zwei Taster 55 und 55' über das LC-Glied und den im Näherungssensor 20 vorgesehenen Oszillator dessen Frequenz modulieren und somit das Ausgangssignal 24 verändern, um zu einem Ergebnis in Form einer Anzeige 31 zu gelangen. Jeder der beiden Taster 55 und 55' kann identisch aufgebaut sein, also auch einen ähnlichen Kondensator 54 bzw. 54'" aufweisen. Eine solche Ähnlichkeit ist aber nicht zwingend notwendig, nur die Induktivität wird mehrfach verwendet und nur die Güte des Systems ändert. Das Prinzip der Fig. 6 kann auf mehr als zwei Schalter erweitert werden, die parallel zu den beiden dargestellten Gliedern angeordnet werden.

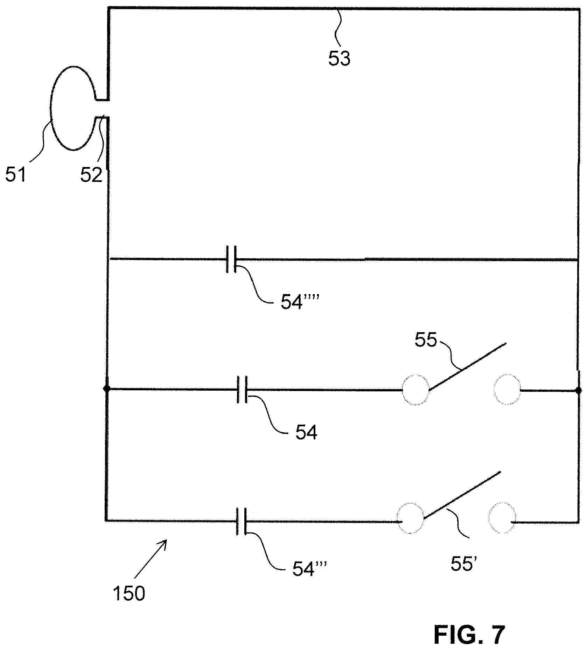

Die Fig. 7 zeigt eine schematische Schaltungsskizze eines sechsten Ausführungsbeispiels eines RF gekoppelten 2- oder mehr-Kanal Schalters 150 gemäss der Erfindung in einer Sicherheitsschaltung. Hier ist zu der Ausgestaltung des Schalters 100 nach Fig. 2 einerseits zusätzlich ein weiterer Kanal mit Kondensator 43'" und 55' wie beim Ausführungsbeispiel nach Fig. 6 vorgesehen, und andererseits zusätzlich ein weiterer Kondensator 54"" parallel zum ersten und zweiten Kondensator 54, 54'" und Taster 55. 55' vorgesehen, der ebenfalls mit den freien Enden der Antenne 51 verbunden. So ist auch bei dieser Schaltung immer mindestens ein Schwingkreis aktiv. Es sind weitere Parallelschaltungen von weiteren Kondensator-Schalter Paaren möglich, um die Anzahl der Kanäle zu erhöhen.

Die obigen Beispiele zeigen verschiedene Anwendungsfälle. Die Fig. 2 und 3 zeigen einen einfachen Taster oder Schalter mit einem LC-Schwingkreis mit einer vorgegebenen Frequenz. Es ist entweder ein LC-Schwingkreis schalterseitig aktiv oder keiner. Die Fig. 4 und 5 zeigen einen einfachen Taster oder Schalter mit einer die Sicherheit erhöhenden Überwachungsfunktion mit zwei LC-Schwingkreisen mit zwei vorgegebenen Frequenzen. Es ist schalterseitig immer ein LC-Schwingkreis aktiv. Ein Mehrfachschalter (hier zwei, aber auch drei oder mehr Schalter sind möglich) mit einer entsprechenden Anzahl von vorzugsweise unterschiedlichen Frequenzen ist in Fig. 6 dargestellt. Es kann keiner, einer oder mehrere Schwingkreise aktiv sein. Schliesslich zeigt Fig. 7 einen Mehrfachschalter (hier zwei, aber auch drei oder mehr Schalter sind möglich) mit einer entsprechenden Anzahl von vorzugsweise unterschiedlichen Frequenzen mit Überwachung, Es ist minimal immer ein Schwingkreis schalterseitig aktiv.

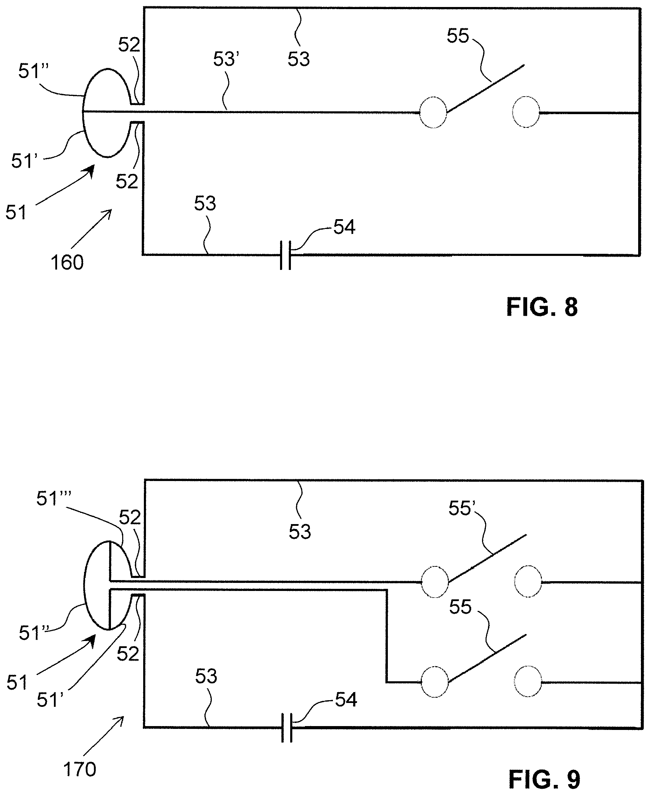

Die Fig. 8 zeigt eine schematische Schaltungsskizze eines siebten Ausführungsbeispiels eines RF gekoppelten Schalters 160 gemäss der Erfindung. Es bestehen zwei Unterschiede zwischen den Ausführungsbeispielen der Fig. 4, 5 und 7 und den Ausführungsbeispielen der Fig. 8 und 9. Der eine liegt darin, dass bei den erstgenannten Beispielen durch Schliessen des Schalters 55 oder der Schalter 55, 55' der Wert der im Schwingkreis geschalteten Kapazität verändert wird, während es bei den letztgenannten Beispielen der Wert der Induktivität ist, der durch Schliessen des Schalters 55 oder der Schalter 55, 55' verändert wird. Die Antenne 51 ist hier im einfachsten Fall wieder als ein nahezu geschlossenes Gebilde ausgelegt, die hier als eine Schlaufe dargestellt ist. Es können natürlich auch mehrere Windungen bestehen. Die beiden freien Enden 52 der Leitungen der Antenne 51 sind über Drahtverbindungen 53 über einen Kondensator 54 geschlossen, so dass sich auf der Schalterseite ein einfaches LC-Glied ergibt. Zusätzlich ist nun aber die Induktivität der Antenne 51 schaltbar, indem zwischen den freien Anschlüssen eine Schalterleitung 53' angeschlossen ist, die die Windung(en) der Antenne 51 in zwei Teilinduktivitäten 51' und 51" unterteilt. Die Schalterleitung 53' ist mit einem der Kontakte eines Tasters oder Schalters 55 verbunden, wobei der weitere Kontakt mit der Drahtverbindung 53 den Schalter parallel zu Kondensator 54 und Teilinduktivität 51' und zu Teilinduktivität 51" alleine schaltet. Somit besteht bei offenem Schalter 55 ein Schwingkreis, aufgebaut aus der Kapazität des Kondensators 54 und der Summe der beiden Teilinduktivitäten 51' und 51", während beim Schliessen des Schalters 55 sich der Schwingkreis bei gleichbleibendem Wert der Kapazität des Kondensators 54 die Induktivität auf die Teilinduktivitäten 51' reduziert.

In praktischen Ausführungen kann die Antenne 51 zwei Windungen aufweisen, wobei ein Abgriff zwischen den Windungen gleiche Teilinduktivitäten 51' und 51" hervorruft. Bei beispielsweise drei Windungen und einem Verhältnis von 1 zu 2 wären dann die Teilinduktivitäten 51' und 51" im gleichen Verhältnis unterschiedlich.

Die Fig. 9 zeigt eine schematische Schaltungsskizze eines achten Ausführungsbeispiels eines RF gekoppelten 2-Kanal Schalters 170 gemäss der Erfindung, wobei immer ein Schwingkreis aktiv ist. Hier sind zwei Schalter oder Taster 55 und 55' vorgesehen, die parallel zum Kondensator 54 geschaltet sind und dabei einerseits, wie beim Beispiel der Fig. 8, der erste Schalter 55 auch parallel zu einer ersten Teilinduktivität 51' geschaltet ist. Der zweite Schalter 55' unterteilt die verbleibende Induktivität erneut in zwei Teilinduktivität 51" und 51'". Bei diesem 2-Kanal Schalter 170 ist also bei offenen Tastern 55 und 55' der LC-Schaltkreis auf Schalterseite durch die Kapazität des Kondensators 54 und die Summe der drei Teilinduktivitäten 51', 51" und 51'" gegeben. Bei Schalten des Tasters 55 wird der verbleibende Teil der Induktivitäten überbrückt und der LC-Schaltkreis ist durch die Teilinduktivität 51' gekennzeichnet. Wird alternativ der Taster 55' gedrückt, so kommen in dem LC-Schaltkreis die beiden Teilinduktivitäten 51' und 51" zum Tragen. Natürlich können auch mehr Unterteilungen der Induktivitäten getroffen werden, so dass auch mehr als 2 Kanäle möglich sind.

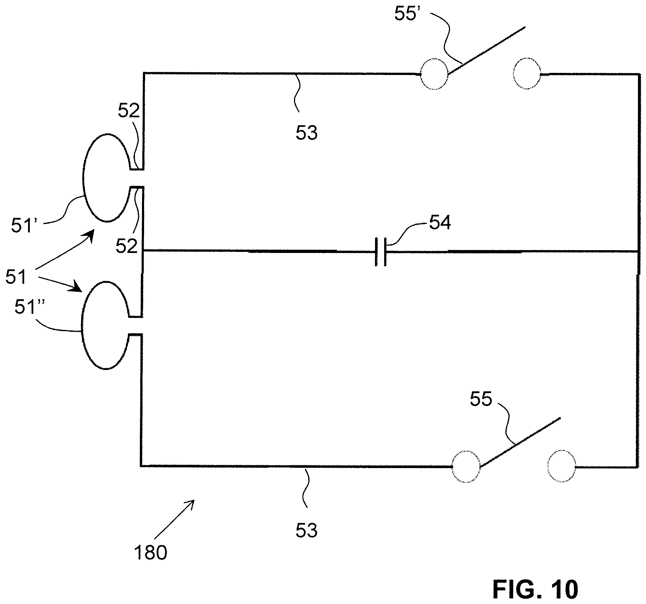

Die Fig. 10 schliesslich zeigt eine schematische Schaltungsskizze eines neunten Ausführungsbeispiels eines RF gekoppelten 2-Kanal Schalters 180 gemäss der Erfindung. Hier sind zwei Ausführungen nach Fig. 2 mit dem gleichen Kondensator 54 zusammengeschaltet, so dass bei geschlossenem Schalter entweder die Induktivität 51' der einen Antenne 51 oder die Induktivität 51" der anderen Antenne wirksam sind. Die Antennen 51 - Bestandteile sind dabei vorteilhafterweise übereinander gelegt. Es ist auch möglich, durch Vorsehen einer Induktivität parallel zum Kondensator 54 eine Situation zu schaffen, bei der immer ein Schwingkreis aktiv ist und der LC-Schaltkreis durch den einen und/oder den anderen Taster verstimmt wird, da diese hier unabhängig voneinander wirken.

**BEZUGSZEICHENLISTE**

| | | | |
|---|---|---|---|
| 10 | RF gekoppelter Schalter | 53 | Drahtverbindung |
| 20 | RF-Sensor | 53' | Schalterleitung |
| 22 | Speisespannung | 54 bis 54"' | Kondensator |
| 23 | LC-Schwingkreis | 55,55' | Taster / Schalter |
| 24 | Ausgangssignal | 100 | Schalteinheit |
| 30 | Auswerteschaltung | 110 | Schalteinheit |
| 31 | Anzeige /Aktor | 120 | Schalteinheit |
| 32 | Auswerteelektronik | 130 | Schalteinheit |
| 34 | Schaltsignal | 140 | Schalteinheit |
| 40 | Spalt | 150 | Schalteinheit |
| 51 | Antenne / RF Glied | 160 | Schalteinheit |
| 51' bis 51"' | Teilinduktivität | 170 | Schalteinheit |
| 52 | freie Enden | 180 | Schalteinheit |

## Patentansprüche

1. Vorrichtung zum Erkennen eines Schaltvorgangs über einen Spalt (40) hinweg, mit einem RF-Sensor (20, 23), umfassend einen Oszillator und ein LC-Glied, mit einem RF gekoppelten Schalter (10), umfassend ein Schaltglied (55), wobei der Schalter (10) im Abstand des Spaltes (40) gegenüber dem LC-Glied des RF-Sensors (20, 23) angeordnet ist, **dadurch gekennzeichnet, dass** der RF gekoppelte Schalter (10) über eine aus mindestens einer Windung bestehenden Antennenspule (51, 51', 51", 51"'), einen Kondensator (54, 54', 54", 54"') und ein Schaltorgan (55, 55') in einem geschlossenen Kreis (53) verfügt, wobei das aus Antennenspule (51) und Kondensator (54) gebildete LC-Glied im Wesentlichen bei einer vorbestimmten Synchronisationsstellung des Schaltorgans (55, 55') im Wesentlichen die gleiche Frequenz wie das LC-Glied des RF-Sensors (20, 23) aufweist, so dass bei einer Änderung der Stellung des Schaltorgans (55, 55') ein entstehender Unterschied in der Last des LC-Glied des RF-Sensors (20, 23) durch eine Auswerteschaltung (32) erfassbar ist.

2. Vorrichtung nach Anspruch 1, wobei das Schaltorgan (55, 55') mindestens einen Schalter, mindestens einen Taster oder ein Element zum Verstimmen des Schwingkreises umfasst.

3. Vorrichtung nach Anspruch 2, wobei die Änderung des Schaltorgans (55, 55') eine Aktion aus der Gruppe des Schliessens eines Schalters oder Tasters, Öffnen eines Schalters oder Tasters oder Verstimmen des Schwingkreises umfasst.

4. Vorrichtung nach einem der Ansprüche 1 bis 3, wobei die Antennenspule (51, 51', 51", 51'") parallel zur Ebene des Spaltes (40) in einer Antennenebene angeordnet ist und das Schaltorgan (55, 55') ein Taster ist, der mittig zur Antennenspule (51, 51'. 51", 51'") angeordnet ist und von der vom Spalt (40) abgewandten Seite des RF gekoppelten Schalters (10) nahe der Antennenebene betätigbar ist.

5. Vorrichtung nach einem der Ansprüche 1 bis 4, wobei das Schaltorgan (55) und der Kondensator (54) parallel zueinander geschaltet sind.

6. Vorrichtung nach einem der Ansprüche 1 bis 4, wobei das Schaltorgan (55) in Serie mit einem Kondensator (54) geschaltet ist, wobei diese Serienverbindung parallel zu einem Basiskondensator (54') geschaltet ist.

7. Vorrichtung nach einem der Ansprüche 1 bis 4, wobei das Schaltorgan (55) parallel zu einem weiteren Kondensator (54") geschaltet ist, wobei diese parallel geschalteten Elemente Schaltorgan und weiterer Kondensator in Serie mit einem Basiskondensator (54) an den Eingang der Antennenschaltung (30) geschaltet ist.

8. Vorrichtung nach einem der Ansprüche 1 bis 4, wobei zwei oder mehr Schaltorgane (55, 55') in Serie mit jeweils einem Kondensator (54, 54"') geschaltet sind, wobei diese zwei oder mehr Serienverbindungen parallel zu dem Eingang der Antennenschaltung (30) geschaltet sind.

9. Vorrichtung nach Anspruch 8, wobei parallel zu den zwei oder mehr Schaltorganen (55,55'), die in Serie mit einem Kondensator (54, 54'") geschaltet sind, parallel dazu ein Basiskondensator (54"") geschaltet ist.

10. Vorrichtung nach einem der Ansprüche 1 bis 4, wobei parallel zu einer Serienschaltung des Kondensators (54) mit einer ersten Teilinduktivität (51') der Antennenschaltung (51) ein Schaltorgan (55) parallel zu einer zweiten Teilinduktivität (51") der Antennenschaltung (30) geschaltet ist.

11. Vorrichtung nach Anspruch 10, wobei die beiden ersten und zweiten Teilinduktivitäten (51', 51") der Antennenschaltung (30) durch einen zwischen diesen vorgesehenen Zwischenabgriff durch die Verbindung (53') zum Schaltorgan (55) realisiert ist, insbesondere durch Realisierung jeder der ersten und zweiten Teilinduktivitäten (51', 51") durch eine vorbestimmte Anzahl von Windungen der Antennenschaltung (51).

12. Vorrichtung nach Anspruch 10 oder 11, wobei mindestens zwei Schaltorgane (55, 55') vorgesehen sind, die jeweils parallel zu einer zugeordneten Teilinduktivität (51", 51"') der Antennenschaltung (30) und parallel zu einer Serienschaltung des Kondensators (54) mit der ersten Teilinduktivität (51') der Antennenschaltung (51) geschaltet ist.

13. Vorrichtung nach einem der Ansprüche 1 bis 12, dass die Auswerteschaltung (32) ausgestaltet ist, um die Amplitude des RF-Sensors (20, 23) zu messen, oder um den Leistungsverbrauch des Oszillators des RF-Sensors (20. 23) zu messen, oder um die Resonanzfrequenz direkt zu ermitteln.
